Europäisches Patentamt

European Patent Office

Office européen des brevets

(19)

(11) EP 0 585 454 B1

(12) **FASCICULE DE BREVET EUROPEEN**

(45) Date de publication et mention
de la délivrance du brevet:
**11.06.1997 Bulletin 1997/24**

(21) Numéro de dépôt: **93918736.5**

(22) Date de dépôt: **10.03.1993**

(51) Int Cl.6: **H03M 1/30**, G01D 5/245

(86) Numéro de dépôt international:
**PCT/FR93/00238**

**WO 93/18588 (16.09.1993 Gazette 1993/22)**

(54) **DISPOSITIF DE COMPTAGE-DECOMPTAGE**

VORRICHTUNG ZUM AUF UND ABZAEHLEN

INCREMENTAL-DECREMENTAL COUNTER

(84) Etats contractants désignés:
**DE ES FR GB IT NL SE**

(30) Priorité: **10.03.1992 FR 9202847**

(43) Date de publication de la demande:
**09.03.1994 Bulletin 1994/10**

(73) Titulaire: **ART TECH GIGADISC ATG**
**31047 Toulouse (FR)**

(72) Inventeur: **BEC, Daniel**
**F-92402 Courbevoie Cédex (FR)**

(74) Mandataire: **Ruellan-Lemonnier, Brigitte et al**
**THOMSON multimedia,**
**46 quai A. Le Gallo**
**92648 Boulogne Cédex (FR)**

(56) Documents cités:
**GB-A- 1 187 868** **US-A- 4 714 913**

## Description

La présente invention concerne les dispositifs de comptage-décomptage.

Les compteurs/décompteurs sont généralement utilisés en robotique et parfois en métrologie. Ils interviennent dans les systèmes permettant de repérer la position de mobiles divers. Ainsi sont-ils présents, par exemple, dans les boucles d'asservissement destinées à commander le positionnement d'axes-moteurs.

Afin de corriger la position d'un objet, l'information donnant la position réelle dudit objet est comparée à une consigne extérieure. L'objet à commander est relié à un codeur de position qui délivre deux signaux en quadrature. Ces signaux sont envoyés dans un compteur/décompteur dont la fonction est de fournir une information de position en code binaire. Cette information est l'adresse absolue de l'objet. Cette adresse absolue ne peut pas être échantillonnée à tout instant : elle n'est définie que dans certaines fenêtres temporelles et en dehors de ces fenêtres elle peut être erronée.

Il est connu de l'homme de l'art que le compteur/décompteur doit alors être équipé d'un registre de sortie commandé en synchronisme avec les signaux issus du codeur de position.

L'invention ne présente pas ces inconvénients.

L'un des objets de l'invention est un dispositif de comptage/décomptage destiné à fournir une adresse absolue en code binaire, ladite adresse permettant de déduire la position d'un objet à partir de signaux issus d'un codeur de position non absolu relié audit objet, caractérisé en ce qu'il comprend des moyens destinés à générer une adresse partielle constituée des bits de plus faible poids de ladite adresse exprimée en code binaire réfléchi ou tout autre code équivalent.

D'autres caractéristiques et avantages de l'invention apparaîtront à la lecture d'un mode de réalisation préférentiel, fait avec référence aux figures ci-annexées dans lesquelles :

- la figure 1 représente le schéma synoptique d'un asservissement de position utilisant un compteur/décompteur selon l'art antérieur,
- la figure 2A représente le schéma synoptique d'un compteur/décompteur selon un mode de réalisation préférentiel de l'invention,
- la figure 2B représente un ensemble de circuits logiques entrant dans la réalisation du compteur-décompteur selon l'invention,
- la figure 3 représente le chronogramme du compteur/décompteur décrit en figure 2,
- la figure 4 représente la courbe de détermination, par extrapolation linéaire, des adresses absolues dans le cas ou le compteur/décompteur ne fournit qu'une adresse partielle,
- la figure 5 représente, de façon symbolique, un algorithme de détermination de l'adresse absolue dans le cas où le compteur/décompteur ne fournit qu'une adresse partielle,
- la figure 6 représente le schéma synoptique de l'asservissement de position utilisant un dispositif compteur/décompteur selon un mode de réalisation préférentiel de l'invention,
- la figure 7A représente le diagramme des états internes d'un compteur-décompteur cyclique à cinq états,
- la figure 7B représente les signaux d'entrée, l'état interne correspondant et les signaux de sortie du compteur cyclique à cinq états,
- la figure 8 représente le schéma synoptique de l'asservissement de position utilisant un compteur/décompteur suivant un second mode de réalisation de l'invention.

Sur toutes les figures, les mêmes repères désignent les mêmes éléments.

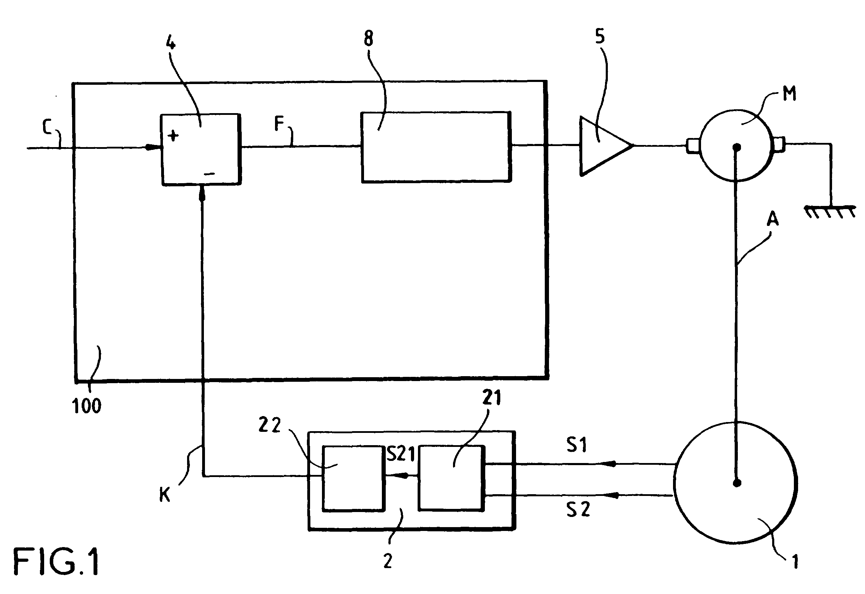

Les asservissements décrits par les figures 1, 6 et 8 sont, pour l'essentiel, réalisés à l'aide d'un microprocesseur. Ainsi, chacun des dispositifs situés dans la zone 100 desdites figures est-il la représentation symbolique d'une opération de l'algorithme d'asservissement.

La figure 1 représente le schéma synoptique d'un asservissement de position utilisant un compteur/décompteur selon l'art antérieur. L'objet à commander est, par exemple, un axe-moteur.

Un codeur 1 recueille la position de l'axe-moteur A du moteur M. De façon générale, ce codeur est un codeur non absolu qui délivre deux signaux S1 et S2 en quadrature.

Pour reconstituer une information donnant la position absolue de l'axe-moteur, on est alors amené à utiliser un compteur/décompteur 2. Le compteur/décompteur 2 est composé de deux dispositifs : un premier dispositif 21 qui contient les circuits permettant d'obtenir, en code binaire, la position de l'axe-moteur A à partir des signaux en quadrature S1 et S2 et un second dispositif 22 représentant le registre de sortie commandé en synchronisme avec les signaux S1 et S2.

Le signal S21 issu du dispositif 21 est un nombre entier exprimé en code binaire. Ce nombre entier est défini avec ambiguïté au moment de la propagation des retenues, soit lors d'un accroissement de sa valeur quand le nombre binaire comporte au moins une succession de "1" contigus, soit lors d'une diminution de sa valeur quand le nombre binaire comporte au moins une succession de "0" contigus.

Le signal S21 n'est donc pas disponible en lecture et il nécessaire d'introduire une logique séquentielle afin de pallier cet inconvénient. C'est à cette fin qu'est introduit le registre de sortie 22.

L'élément de câblage K comporte souvent autant de conducteurs que de bits nécessaires pour coder la position absolue de l'axe moteur. Dans tous les cas il permet d'envoyer au micro-processeur la totalité de l'information de position absolue de l'axe moteur disponible à la sortie du registre 22.

Cette information est comparée à la consigne de position C à l'aide du soustracteur 4. L'écart F issu du soustracteur 4 est envoyé dans le filtre de stabilité 8.

Il est connu de l'homme de l'art qu'une avance de phase est nécessaire afin de stabiliser la boucle. Ce filtre y pourvoie.

Le dispositif 5 est constitué d'un convertisseur numérique-analogique suivi d'un amplificateur qui alimente le moteur en puissance. Le circuit regroupant en cascade tous les éléments qui viennent d'être décrits tend à faire décroître l'écart F quand ledit moteur agit.

Si la position absolue codée en binaire s'exprime à l'aide de N bits, l'élément de câblage K doit compter N fils afin de transmettre l'information en une seule fois ou bien N/n fils afin de transmettre l'information en n fois.

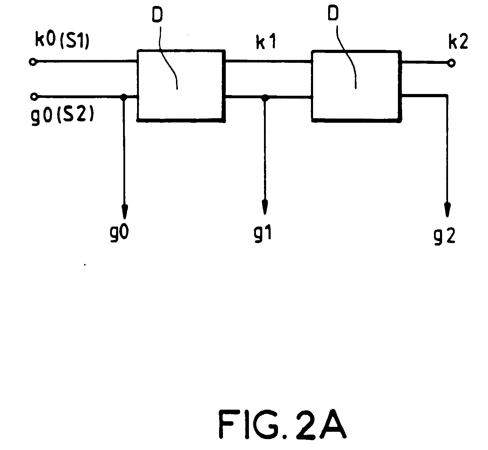

La figure 2A représente le schéma synoptique d'un compteur/décompteur selon le mode de réalisation préférentiel de l'invention. Il a été dit précédemment que les compteurs/décompteurs selon l'art antérieur doivent comprendre un registre de sortie 22 commandé en synchronisme avec les signaux issus du codeur de position. L'invention ne présente pas cet inconvénient car le code binaire utilisé change d'un seul bit d'une combinaison à l'autre. En effet, selon l'invention, la position absolue de l'axe-moteur est codée selon le code binaire réfléchi ou selon tout autre code équivalent. Cela permet donc non seulement de supprimer le registre de sortie 22, mais aussi de prendre en compte à chaque instant le signal de sortie du compteur-décompteur sans avoir à attendre une fenêtre temporelle.

Pour mémoire, le tableau ci-dessous rappelle l'évolution du code binaire réfléchi ou code de Gray quand celui-ci est défini, par exemple, sur trois bits b2, b1, b0 :

| b2 | b1 | b0 |
|----|----|----|
| 0 | 0 | 0 |
| 0 | 0 | 1 |
| 0 | 1 | 1 |
| 0 | 1 | 0 |
| 1 | 1 | 0 |
| 1 | 1 | 1 |
| 1 | 0 | 1 |
| 1 | 0 | 0 |

On voit que ce code suit une évolution telle qu'il y a changement d'un seul bit d'une combinaison à l'autre.

Le compteur/décompteur de la figure 2A fournit, suivant un mode préférentiel de l'invention, une adresse partielle de 3 bits : g2, g1, g0, car, comme on le verra plus loin, il n'est pas nécessaire de transmettre toute l'adresse absolue mais seulement ses bits de plus faible poids.

Les deux signaux S1 et S2 issus du codeur de position sont ici notés k0, pour S1, et g0, pour S2.

Un dispositif D reçoit les deux signaux k0 et g0 et délivre les signaux k1 et g1. De même, un second dispositif D reçoit les deux signaux k1 et g1 et délivre les signaux k2 et g2 (k2 n'est pas utilisé).

Les circuits contenus dans les dispositifs D sont des circuits logiques combinés de façon que les différents signaux gi et ki (i = 0, 1, 2) soient reliés comme suit :

$$gi = \overline{g}(i-1) \bullet gi + g(i-1) \bullet (k(i-1) \oplus ki)$$

$$ki = g(i-1) \bullet ki + \overline{g}(i-1) \bullet (k(i-1) \oplus gi)$$

Dans les expressions ci-dessus $\overline{g}i$ représente le complément logique de $gi$. Les différentes opérations représentées symboliquement par les signes "•", "+", et "⊕" sont les fonctions connues de l'homme de l'art sous les noms respectifs "et", "ou" et "ou exclusif".

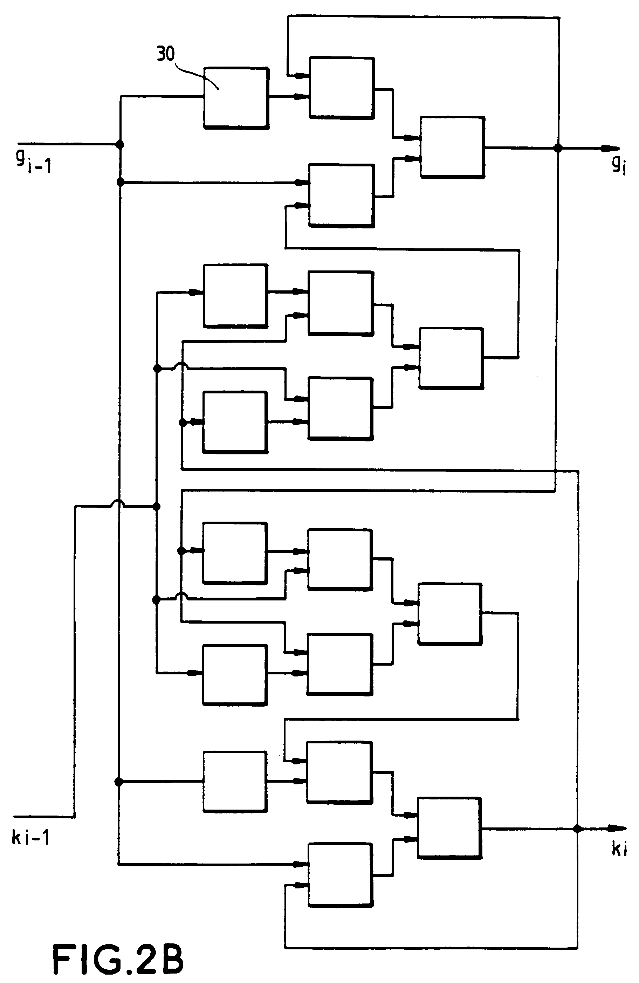

Les circuits logiques permettant de générer les signaux gi et ki à partir des signaux g(i-1) et k(i-1) sont représentés en figure 2B.

Il s'agit d'une combinaison de circuits logiques élémentaires 30 de type NAND ou NON ET. Il est connu de l'homme de l'art que d'autres circuits élémentaires que les circuits NAND permettraient d'arriver au même résultat.

Selon le mode de réalisation décrit, les deux dispositifs D permettent de générer une adresse partielle de 3 bits. De façon générale, P - 1 dispositifs D permettent de générer une adresse partielle de P bits.

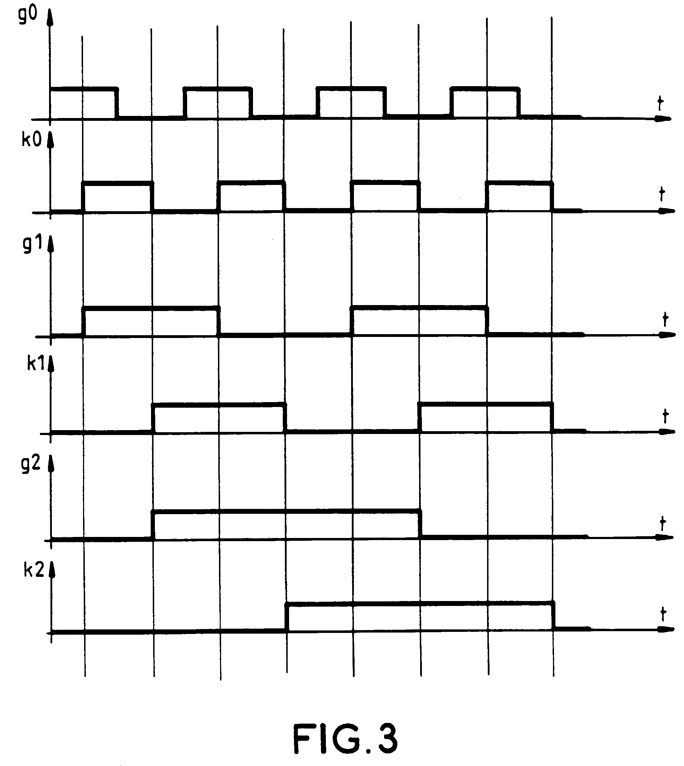

La figure 3 représente le chronogramme du compteur/décompteur décrit en figure 2A. Les courbes décrivant les signaux gi et ki (i = 0, 1, 2) en fonction du temps ne présentent aucune erreur dans leur évolution. Lors d'un changement d'état un seul chiffre binaire commute et le nombre entier codé en binaire est connu sans ambiguïté.

Selon l'invention, il n'est pas nécessaire que le compteur-décompteur génère une adresse absolue pour créer l'information donnant la position de l'axe-moteur. Une adresse partielle suffit sous réserve de reconstituer l'adresse absolue.

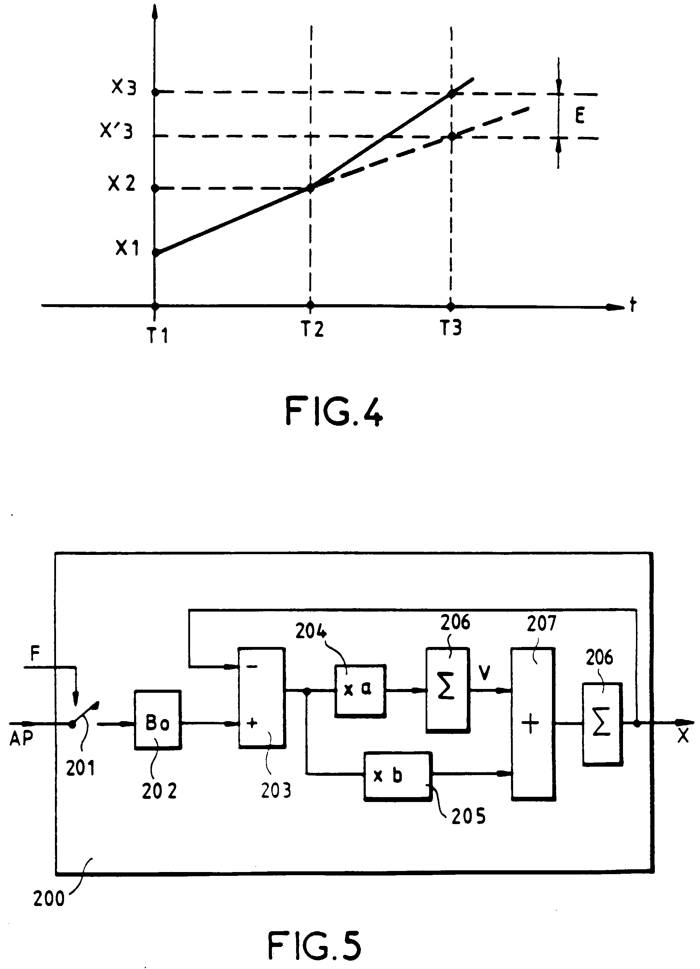

La figure 4 représente le principe de calcul d'un algorithme permettant de reconstituer l'adresse absolue par extrapolation linéaire. Cet algorithme est le plus simple démontrant la faisabilité de la restitution de l'adresse absolue à partir de ses bits de plus faible poids. Son principe est basé sur le fait que si l'on connaît le reste de la division modulo Q d'une grandeur X à chaque instant et si l'on connaît les deux premières adresses absolues X1 et X2, on peut en déduire les adresses absolues suivantes. Q représente la quantification de l'adresse partielle : pour 3 bits $Q = 2^3 = 8$.

Sur la courbe de la figure 4 l'adresse Xj (j = 1, 2, 3) est l'adresse absolue qui doit être fournie à l'instant Tj.

Les instants T1, T2, T3 sont tels que

$$T3 - T2 = T2 - T1 = T.$$

X'3 est l'extrapolation linéaire de X1 et X2.
Il vient donc :

$$X'3 - X2 = X2 - X1.$$

Soit :

$$X'3 = 2 X2 - X1.$$

L'erreur E correspondant à l'écart entre l'adresse X3 à fournir et l'adresse X'3 obtenue par extrapolation linéaire est :

$$E = X3 - X'3$$

Soit :

$$E = X3 - 2 X2 + X1$$

Si E est inférieur à Q/2, alors :

$$E = (X3 \bmod Q - 2 X2 + X1) \bmod Q$$

$$\text{Soit } E = (x3 - 2 X2 + X1) \bmod Q$$

avec x3 = X3 mod Q, x3 représentant la mesure des bits de plus faible poids.
$\gamma$ max étant l'accélération maximale de la grandeur X, l'erreur maximale E max que l'on peut avoir est :

$$E \text{ max} = \gamma \text{ max} \times \Delta T^2. \text{ Il faut donc } Q \rangle 2 \times \gamma \text{ max} \times \Delta T^2.$$

Dans ce cas, l'adresse X3 fournie s'écrit donc :

$$X3 = 2\,X2 - X1 + (x3 - 2\,X2 + X1)\ \text{mod}\ Q.$$

Les calculs décrits ci-dessus sont réalisés à l'aide d'un microprocesseur. Selon le mode de réalisation préférentiel choisi, ces calculs sont effectués par le microprocesseur calculant l'erreur de position de l'axe-moteur à commander.

En plus de la fonction d'extrapolation et de reconstruction de l'adresse absolue, l'algorithme selon l'invention permet de contrôler la vraissemblance des données. L'erreur E est alors comparée à une valeur de vraissemblance EV. La valeur EV est choisie petite devant E max. Si l'erreur E est inférieure ou égale à EV, l'algorithme se poursuit sans détour. Sinon la valeur de l'erreur E est forcée à zéro, permettant ainsi la suppression des échantillons aberrants.

La figure 5 représente, de façon symbolique, un autre algorithme permettant la reconstruction de l'adresse absolue. Cet algorithme est symboliquement représenté par le dispositif 200. A l'intérieur de ce dispositif symbolique, chaque opération mathématique est représentée par un dispositif symbolique élémentaire. Chacune de ces opérations élémentaires est connue de l'homme de l'art. On se contente de la rappeler pour effectuer une description complète de l'algorithme.

L'adresse partielle AP, constituée par les bits de plus faible poids de l'adresse absolue, est envoyée dans le dispositif symbolique 200 et l'adresse absolue X est récupérée en sortie dudit dispositif. Les différents dispositifs symboliques élémentaires (201, 202, 203, 204, 205, 206, 207) sont combinés de façon que les adresses AP et X soient reliées comme suit :

$$\frac{X}{AP} = \frac{b \times \Sigma + a \times \Sigma^2}{1 + b \times \Sigma + a \times \Sigma^2}$$

avec

$$\Sigma = \frac{1}{1 - z^{-1}}$$

et, comme cela est connu de l'homme de l'art, $z = e^{i\omega T}$ $\omega$ étant la pulsation, au sens de l'analyse de Fourrier, du signal associé à l'adresse partielle AP

et $T = \frac{1}{F}$, F étant la fréquence d'échantillonnage du signal associé à l'adresse partielle AP, ledit échantillonnage étant symbolisé par l'interrupteur 201 et le maintien de la valeur de l'échantillon étant assuré jusqu'à l'arrivée de l'échantillon suivant par le dispositif 202.

Le multiplicateur 204, de facteur multiplicatif a, détermine le filtre passe-bas pour l'adresse absolue X, alors que le multiplicateur 205, de facteur multiplicatif b, donne la constante de temps du filtre passe-bas de la vitesse.

Les dispositifs 206 symbolisent l'opération

$$\Sigma = \frac{1}{1 - z^{-1}},$$

c'est-à-dire l'addition de la valeur de chaque échantillon nouveau, présent à l'entrée du dispositif, à la valeur qu'avait sa sortie au moment de l'arrivée de cet échantillon.

Enfin le dispositif 203 symbolise la différence effectuée entre les signaux provenant respectivement du second dispositif 206 et du dispositif 202, alors que le dispositif 207 symbolise la somme effectuée sur les deux signaux provenant respectivement du dispositif 202 et du premier dispositif 206.

Cet algorithme permet la modélisation et l'identification de la vitesse par moyennage exponentiel. Il faut noter qu'il amoindrit l'effet des échantillons entachés d'erreur à l'aide du filtrage qu'il opère sur lesdits échantillons.

Selon le mode de réalisation préférentiel, on reconstitue une adresse absolue complète de N bits à partir d'une adresse partielle de 3 bits issue du compteur-décompteur. L'information donnée par une adresse partielle de 2 bits est insuffisante car on ne peut lever l'ambiguïté sur la position de l'axe-moteur pour certaines valeurs précises de la vitesse. Pour plus de sécurité, en particulier en présence de bruit important sur le signal de position de l'axe-moteur, on peut être amené à augmenter la redondance de l'adresse partielle en augmentant son nombre de bits, par exemple en passant à 4 bits ou plus. Mais 3 bits suffisent en général, en l'absence de bruit important, pour reconstituer une adresse absolue quelconque complète avec un minimum de redondance.

Quel que soit l'algorithme de reconstruction de l'adresse absolue, l'initialisation des adresses absolues est faite à l'aide d'un senseur extérieur. Elle est faite, comme cela est connu de l'homme de l'art, à l'aide d'une butée de position connue, ladite position étant relevée à vitesse nulle.

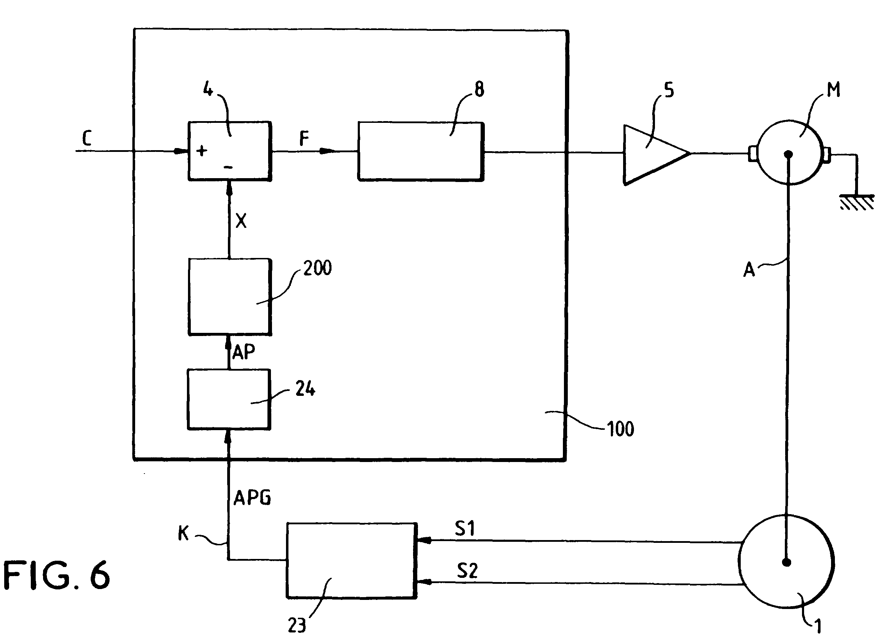

La figure 6 représente le schéma synoptique d'un asservissement de position utilisant un dispositif compteur/décompteur selon le mode de réalisation préférentiel de l'invention.

Le codeur 1 recueille la position de l'axe-moteur A et délivre les deux signaux S1 et S2 en quadrature. L'information issue du compteur/décompteur 23 est codée en code de Gray à l'aide, par exemple, de 3 bits.

Dans ces conditions, l'élément de câblage K est constitué de 3 fils reliés au microprocesseur 100. Il a été dit précédemment que 3 bits permettent de reconstituer une adresse absolue de N bits. Selon le mode de réalisation préférentiel de l'invention N = 24. C'est donc un avantage de l'invention que de pouvoir transmettre en une seule fois et à n'importe quel instant l'information permettant de reconstituer l'adresse absolue à l'aide, par exemple, de 3 fils au lieu de 24.

L'élément de câblage K envoie l'adresse partielle codée en code de Gray APG, constituée préférentiellement des 3 bits g0, g1, g2, sur le dispositif 24, qui convertit ladite adresse partielle en une adresse partielle exprimée en binaire AP. Le dispositif 24 est connu de l'homme de l'art et n'est donc pas décrit.

L'algorithme 200 de reconstruction permet alors de générer l'adresse absolue de position qui, comparée à la consigne C, donne l'écart de position F.

Les dispositifs 8 et 5 sont les mêmes que ceux décrits en relation avec la figure 1.

Dans les algorithmes d'extrapolation et de reconstruction d'adresse absolue décrits précédemment la vitesse est calculée soit sur les deux échantillons connus précédant immédiatement le nouvel échantillon dont on veut extrapoler l'adresse comme cela est décrit en référence à la figure 4, soit à partir de tous les échantillons précédents avec un moyennage de type exponentiel comme cela est utilisé dans l'extrapolation de l'adresse décrite en référence à la figure 5. La vitesse peut aussi être calculée à partir de l'échantillon précédant immédiatement le nouvel échantillon, dont on veut extrapoler l'adresse, et d'un échantillon beaucoup plus ancien de façon à rendre l'imprécision de la vitesse moins sensible à l'imprécision de l'adresse des deux échantillons servant à la déterminer. Tout autre méthode combinant les adresses d'échantillons plus anciens à l'adresse du dernier échantillon connu pour obtenir une valeur de la vitesse est utilisable dans le dispositif suivant l'invention. Et il faut noter que la précision avec laquelle est connue ladite vitesse est plus importante que l'égalité de ladite vitesse à la vitesse réelle de l'objet au temps où elle est calculée, l'erreur systématique introduite sur ladite vitesse pouvant toujours être évaluée, majorée et prise en compte dans les limites de fonctionnement de l'algorithme.

Si l'on reprend les équations écrites dans le cas de l'extrapolation linéaire la plus simple décrite en référence à la figure 4, il vient en y introduisant la vitesse V :

$$X'3 = X2 + V \times T$$

$$E = X3 - X2 - V \times T$$

L'incertitude absolue sur l'erreur E que l'on note $\Delta E$ est :

$$\Delta E = \Delta X_3 + \Delta X_2 + \Delta (V \times T)$$

Les valeurs des X étant quantifiées, les erreurs sur X3 et X2 sont donc égales à un pas de quantification que l'on prend comme unité, soit :

$$\Delta X_3 = \Delta X_2 = 1$$

Pour restituer l'adresse X3 sans ambiguïté il faut avoir :

$$Q > 2 (E \max + \Delta E),$$

soit

$$Q > 2 (\gamma \max \times T^2 + \Delta X_3 + \Delta X_2 + \Delta (V \times T)$$

$\Delta (V \times T) = V \times \Delta T + T \times \Delta V \cong T \times \Delta V$, car la période d'échantillonnage est très précise : elle est fournie par l'horloge de référence de temps de tout le dispositif, qui peut être une horloge à quartz.

Il vient donc :

$$Q > 2 (\Delta X_3 + \Delta X_2) + 2 (\gamma \max \times T^2 + T \times \Delta V).$$

Avec les valeurs maximales de $\Delta X_2$ et $\Delta X_3$ il vient :

$$Q > 4 + 2 (\gamma \max \times T^2 + T \times \Delta V)$$

Avec une vitesse calculée de façon à limiter son imprécision provenant de l'imprécision des adresses absolues précédentes, et avec une accélération restant faible ou avec un échantillonnage à fréquence élevée, donc avec T petit, la quantité $2 (\gamma \max \times T^2 + T \times \Delta V)$ peut être maintenue bien inférieure à 1, si bien que pour pouvoir extrapoler sans ambiguïté l'adresse X3 il suffit de prendre $Q \geq 5$. Au lieu d'utiliser un compteur binaire on peut alors utiliser un compteur cyclique, dit en anneau. La valeur la plus faible utilisable étant $Q = 5$, on peut utiliser un compteur cyclique à cinq états.

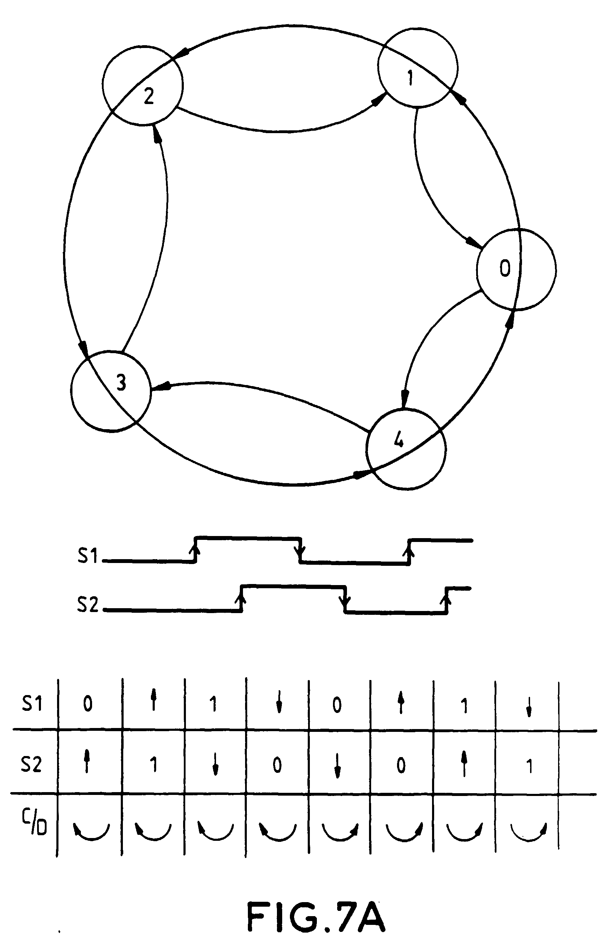

La figure 7A représente le diagramme des états internes ainsi que la table de fonctionnement d'un compteur-décompteur à cinq états. L'occurence d'un front de l'un des deux signaux S1 ou S2 provenant du codeur entraîne suivant l'état de l'autre signal une progression de l'état interne dudit codeur-décodeur dans le sens positif ou dans le sens négatif comme cela apparaît sur ladite table de fonctionnement.

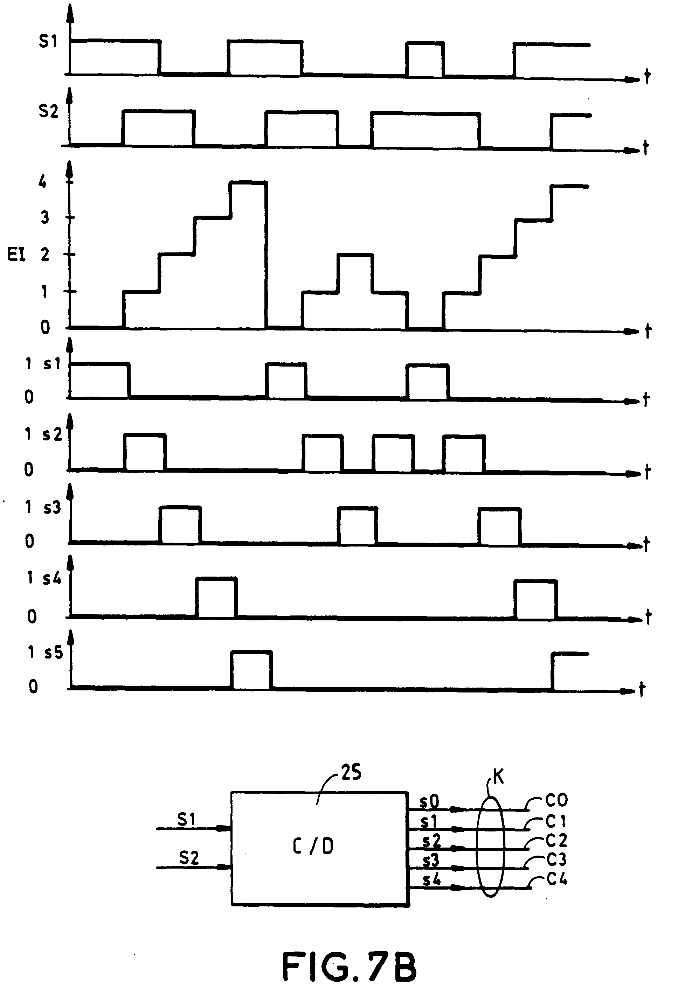

La figure 7B représente pour deux signaux S1 et S2 provenant du codeur (1) entrant dans le compteur-décompteur 25, l'état interne EI correspondant dudit compteur-décompteur et les signaux de sortie dans le cas où l'on utilise un élément de câblage K à cinq conducteurs C0, C1, C2, C3, et C4 pour transmettre les cinq positions élémentaires de l'adresse partielle vers le microprocesseur. Ce choix est judicieux quand on veut à la fois vitesse et précision dans le positionnement d'un objet : par exemple un axe-moteur à mouvement rapide doté d'un codeur dont la graduation présente un grand nombre de marques par tour. La durée de transmission de l'adresse partielle vers le microprocesseur gérant la position de l'axe-moteur est alors minimisée. Les cinq signaux s0, s1, s2, s3, et s4 portés respectivement par les conducteurs C0, C1, C2, C3 et C4 représentent chacun l'état du compteur 25 portant la même référence (0, 1, 2, 3, 4). Pour avoir la possibilité, comme dans le cas du code de Gray, de pouvoir échantillonner l'adresse venant du compteur-décompteur à tout instant, les signaux si (i = 0, 1, 2, 3, 4) sont prolongés légèrement au-delà du temps de changement d'état du compteur-décompteur de façon à ne jamais avoir un niveau 0 sur les cinq conducteurs simultanément ; on peut convenir, en cas de présence simultanée de deux signaux si au niveau 1, de choisir celui qui correspond au premier état rencontré dans le sens positif des changements d'état du compteur-décompteur. Ainsi 0 prime-t-il sur 1, 1 sur 2, 2 sur 3, 3 sur 4 et 4 sur 0. Dans ces conditions, comme dans le cas du code de Gray l'erreur est au plus d'un pas de quantification du codeur.

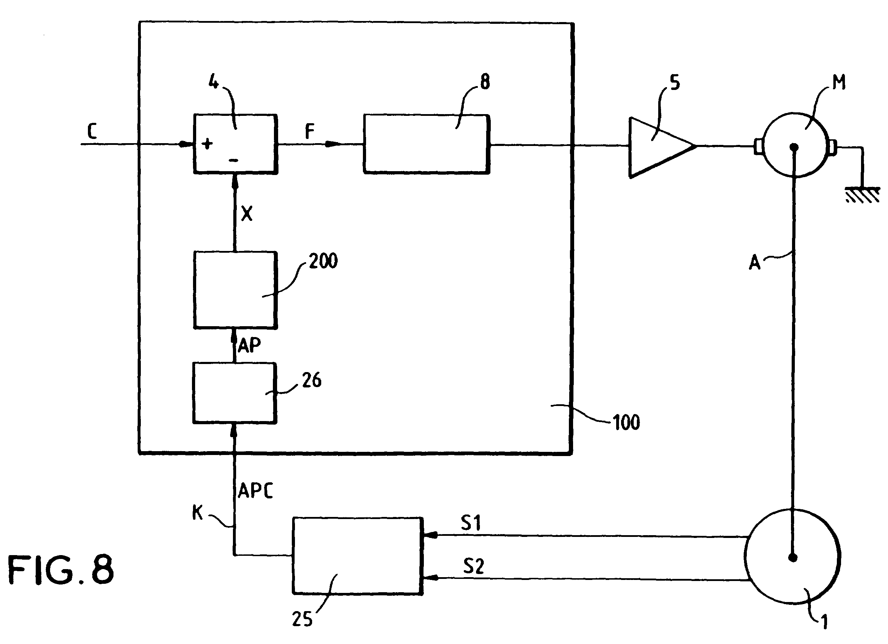

La figure 8 représente le schéma synoptique d'un asservissement de position utilisant un dispositif compteur-décompteur selon un second mode de réalisation de l'invention. Ce dispositif ne diffère du précédent que par le compteur-décompteur. Un compteur-décompteur cyclique 25 du même type que celui décrit précédemment (cf. figures 7A et 7B) est utilisé. Un dispositif 26 permet de convertir en adresse partielle AP exprimée en code binaire l'adresse partielle APC générée par le compteur-décompteur. Ce dispositif est connu de l'homme de l'art et il est inutile de le décrire dans la présente demande. Le reste de la description est identique à ce qui a été décrit en figure 6.

## Revendications

1. Dispositif de comptage-décomptage destiné à fournir une adresse absolue (X) de N bits en code binaire, ladite adresse permettant de déduire la position d'un objet à partir de deux signaux (S1, S2) issus d'un codeur de position non absolu (1) relié audit objet, caractérisé en ce qu'il comprend des moyens (23, 25) destinés à générer une première adresse partielle(APG, APC) exprimée dans un code différent du code binaire et limitée aux bits de plus faible poids de l'adresse absolue et un microprocesseur (100) relié auxdits moyens et permettant de transformer ladite première adresse partielle en ladite adresse absolue (X).

2. Dispositif selon la revendication 1, caractérisé en ce que le microprocesseur (100) comprend des premiers moyens (24, 26) destinés à convertir la première adresse partielle (APG, APC) en une deuxième adresse partielle (AP) exprimée en code binaire et des seconds moyens (200) permettant de reconstituer l'adresse absolue (X) à partir de la deuxième adresse partielle (AP) à l'aide d'un algorithme de reconstruction.

3. Dispositif selon la revendication 2, caractérisé en ce que les moyens (23) destinés à générer une première adresse partielle (APG) comprennent P - 1 sous-ensembles (D), le sous-ensemble de rang i (i = 1, 2, ..., P -1) générant deux signaux (gi, ki) à partir des deux signaux issus du sous-ensemble de rang i-1 qui le précède, l'un (gi) des deux signaux générés par le sous-ensemble de rang i constituant le bit de rang i de ladite première adresse partielle exprimée en code binaire réfléchi, le sous-ensemble de rang 1 ayant pour signal d'entrée les deux signaux (S1, S2) issus du codeur de position.

4. Dispositif selon la revendication 2, caractérisé en ce que les moyens (25) destinés à générer une première adresse partielle (APC) comprennent un compteur-cyclique à au moins cinq états.

5. Dispositif selon l'une quelconque des revendications 2 à 4, caractérisé en ce que l'algorithme de reconstruction de l'adresse absolue (X) est un algorithme d'extrapolation linéaire.

6. Dispositif selon l'une quelconque des revendications 2 à 4, caractérisé en ce que l'algorithme de reconstruction de l'adresse absolue X à partir de l'adresse partielle AP est un algorithme de modélisation et d'identification de la vitesse de l'objet par moyennage exponentiel tel que :

$$\frac{X}{AP} = \frac{b \times \Sigma + a \times \Sigma^2}{1 + b \times \Sigma + a \times \Sigma^2}$$

avec

$$\Sigma = \frac{1}{1 - Z^{-1}}$$

et $Z = e^{i\omega T}$

$\omega$ étant la pulsation, au sens de l'analyse de Fourier, du signal associé à l'adresse partielle AP,

et $T = \frac{1}{F}$, F étant la fréquence d'échantillonnage du signal associé à l'adresse partielle AP.

7. Dispositif selon la revendication 5, caractérisé en ce que l'algorithme de reconstruction comprend un algorithme permettant de contrôler la vraissemblance des données brutes représentant la mesure des bits de plus faible poids de l'adresse absolue.

**Patentansprüche**

1. Vorwärts-Rückwärts-Zählvorrichtung, die dazu bestimmt ist, eine absolute Adresse (X) aus N Bits im Binärcode zu liefern, wobei die besagte Adresse ermöglicht, die Position eines Objekts aus zwei Signalen (S1, S2) abzuleiten, die von einem mit dem besagten Objekt verbundenen nicht absoluten Positionscodierer (1) ausgegeben wurden, dadurch gekennzeichnet, daß sie Mittel (23, 25), die dazu bestimmt sind, eine erste partielle Adresse (APG, APC) zu erzeugen, die in einem vom Binärcode verschiedenen Code ausgedrückt und auf die Bits mit niedrigerem Stellenwert der absoluten Adresse beschränkt ist, und einen Mikroprozessor (100) umfaßt, der mit den besagten Mitteln verbunden ist und gestattet, die besagte erste partielle Adresse in die besagte absolute Adresse (X) zu konvertieren.

2. Vorrichtung nach Anspruch 1, dadurch gekennzeichnet, daß der Mikroprozessor (100) erste Mittel (24, 26), die dazu bestimmt sind, die erste partielle Adresse (APG, APC) in eine zweite partielle Adresse (AP) zu konvertieren, die im Binärcode ausgedrückt ist, und zweite Mittel (200) umfaßt, die es gestatten, die absolute Adresse (X) ausgehend von der zweiten partiellen Adresse (AP) mit Hilfe eines Wiederherstellungsalgorithmus wiederherzustellen.

3. Vorrichtung nach Anspruch 2, dadurch gekennzeichnet, daß die Mittel (23), die dazu bestimmt sind, eine erste partielle Adresse (APG) zu erzeugen, P - 1 Unterbaugruppen (D) umfassen, wobei die Unterbaugruppe vom Rang i (i = 1, 2, ..., P-1) aus den beiden Signalen, die von der ihr vorangehenden Unterbaugruppe vom Rang i-1 ausgegeben wurden, zwei Signale (gi, ki) erzeugt, wobei das eine (gi) der beiden von der Unterbaugruppe vom Rang i erzeugten Signale das Bit vom Rang i der besagten ersten, im reflektierten Binärcode ausgedrückten partiellen Adresse darstellt, wobei die Unterbaugruppe vom Rang 1 als Eingangssignal die beiden vom Positionscodierer (S1, S2) ausgegebenen Signale hat.

4. Vorrichtung nach Anspruch 2, dadurch gekennzeichnet, daß die Mittel (25), die dazu bestimmt sind, eine erste partielle Adresse (APC) zu erzeugen, einen zyklischen Zähler mit mindestens fünf Zuständen umfassen.

5. Vorrichtung nach einem der Ansprüche 2 bis 4, dadurch gekennzeichnet, daß der Algorithmus zur Wiederherstellung der absoluten Adresse (X) ein Algorithmus der linearen Exrapolation ist.

6. Vorrichtung nach einem der Ansprüche 2 bis 4, dadurch gekennzeichnet, daß der Algorithmus zur Wiederherstellung der absoluten Adresse (X) aus der partiellen Adresse AP ein Algorithmus zur Modellierung und Identifizierung der Geschwindigkeit des Objekts durch exponentielle Mittelwertbildung ist, derart, daß gilt:

$$\frac{X}{AP} = \frac{b \times \Sigma + a\,\Sigma^2}{1 + b \times \Sigma + a\,\Sigma^2}$$

mit

$$\Sigma = \frac{1}{1 - z^{-1}},$$

und $Z = e^{i\omega T}$,
wobei $\omega$ die Kreisfrequenz, im Sinne der Fourier-Analyse, des zu der partiellen Adresse AP gehörigen Signals ist,
und $T = \frac{1}{F}$, wobei F die Abtastfrequenz des zu der partiellen Adresse AP gehörigen Signals ist.

7. Vorrichtung nach Anspruch 5, dadurch gekennzeichnet, daß der Wiederherstellungsalgorithmus einen Algorithmus umfaßt, der es ermöglicht, die Wahrscheinlichkeit der Ausgangsdaten, welche den Meßwert der Bits mit niedrigerem Stellenwert der absoluten Adresse darstellen, zu kontrollieren.

## Claims

1. Forward/backward counting device intended for providing an absolute address (X) of N bits in binary code, the said address enabling the position of an object to be deduced from two signals (S1, S2) leaving a non-absolute position coder (1) linked to the said object, characterized in that it comprises means (23, 25) intended for generating a first partial address (APG, APC) expressed in a code which differs from the binary code and is limited to the lowest order bits of the absolute address and a microprocessor (100) linked to the said means and enabling the said first partial address to be transformed into the said absolute address (X).

2. Device according to Claim 1, characterized in 26) intended for converting the first partial address (APG, APC) into a second partial address (AP) expressed in binary code and second means (200) enabling the absolute address (X) to be reconstructed from the second partial address (AP) with the aid of a reconstruction algorithm.

3. Device according to Claim 2, characterized in that the means (23) intended for generating a first partial address (APG) comprise P - 1 sub-assemblies (D), the sub-assembly of rank i (i = 1, 2, ..., P-1) generating two signals (gi, ki) from the two signals leaving the sub-assembly of rank i - 1 which precedes it, one (gi) of the two signals generated by the sub-assembly of rank i constituting the bit of rank i of the said first partial address expressed in reflected binary code, the sub-assembly of rank 1 having the two signals (S1, S2) leaving the position coder as input signal.

4. Device according to Claim 2, characterized in that the means (25) intended for generating a first partial address (APC) comprise a cyclic counter with at least five states.

5. Device according to any one of Claims 2 to 4, characterized in that the algorithm for reconstructing the absolute address (X) is a linear extrapolation algorithm.

6. Device according to any one of Claims 2 to 4, characterized in that the algorithm for reconstructing the absolute address X from the partial address AP is an algorithm for modelling and identifying the speed of the object by exponential averaging such that:

$$\frac{X}{AP} = \frac{b \times \Sigma + a \times \Sigma^2}{1 + b \times \Sigma + a \times \Sigma^2}$$

with

$$\Sigma = \frac{1}{1 - Z^{-1}}$$

and $Z = e^{iwT}$

w being the pulsatance, in the Fourier analysis sense, of the signal associated with the partial address AP,

and $T = \frac{1}{F}$, F being the frequency for sampling the signal associated with the partial address AP.

7. Device according to Claim 5, characterized in that the reconstruction algorithm comprises an algorithm allowing the monitoring of the likelihood of the raw data representing the measure of the lowest order bits of the absolute address.

FIG.1

EP 0 585 454 B1

FIG. 2A

FIG.2B

FIG.3

FIG.4

FIG.5

FIG. 6

FIG.7A

FIG.7B

EP 0 585 454 B1

# FIG.8